# EUROPÄISCHE PATENTANMELDUNG

(11) **EP 3 915 704 A1**
(43) Veröffentlichungstag der Anmeldung: **01.12.2021**
(21) Anmeldenummer: 21176223.2
(22) Anmeldetag: 27.05.2021
(51) Int. Cl.: B22F 10/28, B22F 7/08, B22F 5/10, B22F 10/47, B22F 10/62, B22F 12/90, B33Y 10/00, B33Y 80/00, H05K 1/00, B22F 5/04

(54) **VERFAHREN ZUR PULVERBETTBASIERTEN ADDITIVEN HERSTELLUNG EINES BAUTEILS MIT INTEGRIERTER LEITERBAHN**

(30) Priorität: 28.05.2020 DE 102020206664
(71) Anmelder: FRAUNHOFER-GESELLSCHAFT zur Förderung der angewandten Forschung e.V., 80686 München (DE)
(72) Erfinder: Binder, Maximilian, 86159 Augsburg (DE); Schlick, Georg, 86159 Augsburg (DE); Anstätt, Christine, 86159 Augsburg (DE)
(74) Vertreter: Pfenning, Meinig & Partner mbB

(57) **Zusammenfassung**

Die vorliegende Erfindung bezieht sich auf ein Verfahren zur Herstellung eines Bauteils mit einer zumindest teilweise innerhalb des Bauteils verlaufenden Leiterbahn mittels eines pulverbettbasierten, additiven Fertigungsverfahrens, wobei das Verfahren umfasst: Erstellen eines digitalen Modells des Bauteils und eines digitalen Modells der Leiterbahn, Erstellen eines digitalen Gesamtmodells, wobei das Modell der Leiterbahn innerhalb des Modells des Bauteils positioniert wird, gemeinsames Fertigen des Bauteils und der zumindest teilweise innerhalb des Bauteils verlaufenden Leiterbahn mittels des pulverbettbasierten, additiven Fertigungsverfahrens.

## Beschreibung

Die vorliegende Erfindung bezieht sich auf ein Verfahren zur Herstellung eines Bauteils mit einer zumindest teilweise innerhalb des Bauteils verlaufenden Leiterbahn. Weiterhin bezieht sich die Erfindung auf ein Bauteil mit einer zumindest teilweise innerhalb des Bauteils verlaufenden Leiterbahn und insbesondere mit einem sich innerhalb des Bauteils befindlichen Sensors und/oder Aktors.

Dieser Tage liegt die Fertigung von Leiterbahnen mittels additiver Fertigungsverfahren im Fokus der Forschung. Es wird hierbei versucht in Strukturbauteile aus z. B. Metall durch einen Multimaterialprozess einen nichtleitenden Werkstoff (Isolator) mit einzudrucken, um in diesen wiederum eine Leiterbahn hinein drucken zu können. Ein weit verbreitetes Verfahren ist das metallverarbeitende Laserstrahlschmelzen. Die große Herausforderung des Leiterbahnendrucks ist bei diesem Verfahren, dass sich nur wenige isolierende Materialien für eine Verarbeitung eignen. Die Verarbeitung der isolierenden Materialien ist zudem sehr schwierig umzusetzen, die Bauteileigenschaften anschließend mit vielen Rissen und Poren durchzogen. Doch auch bei allen anderen metallbasierten, additiven Verfahren, wie beispielsweise Binder Jetting, Kaltgasspritzen oder Auftragsschweißverfahren, gibt es Probleme Leiterbahnen im Prozess mit hinein zu drucken.

Derzeit können Leiterbahnen nur in kunststoffbasierte Bauteile hinein gedruckt werden, z. B. durch Verwendung von leitfähigen Klebstoffen. Des Weiteren besteht die Alternative Elektronik oder Kabel im additiven Fertigungsprozess einzulegen. Diese Möglichkeit ist jedoch recht unflexibel und aufwendig in der Umsetzung und findet bisher nur selten Anwendung.

Die Aufgabe der vorliegenden Erfindung ist es daher, ein Verfahren zur Herstellung eines Bauteils bereitzustellen, welches eine innerhalb des Bauteils verlaufende Leiterbahn aufweist und von hoher Herstellungsqualität, insbesondere ohne Risse, Poren etc. ist. Eine weitere Aufgabe der vorliegenden Erfindung ist es, ein qualitativ hochwertiges Bauteil bereitzustellen, welches eine innerhalb des Bauteils verlaufende Leiterbahn und/oder einen sich innerhalb des Bauteils befindlichen Sensor und/oder Aktor aufweist.

Die Aufgabe der vorliegenden Erfindung wird durch ein Verfahren gemäß dem unabhängigen Anspruch 1 und durch das Bauteil gemäß dem unabhängigen Anspruch 9 gelöst. Vorteilhafte Weiterbildungen der Erfindung sind in den abhängigen Ansprüchen aufgeführt.

Das erfindungsgemäße Verfahren zur Herstellung eines Bauteils mit einer zumindest teilweise innerhalb des Bauteils verlaufenden Leiterbahn mittels eines pulverbasierten, additiven Fertigungsverfahrens umfasst die folgenden Schritte: Erstellen eines digitalen Modells des Bauteils und eines digitalen Modells der Leiterbahn, Erstellen eines digitalen Gesamtmodells, wobei das Modell der Leiterbahn innerhalb des Modells des Bauteils positioniert wird, gemeinsames Fertigen des Bauteils und der innerhalb des Bauteils verlaufenden Leiterbahn mittels des pulverbasierten, additiven Fertigungsverfahrens auf Grundlage des digitalen Gesamtmodells.

Das erfindungsgemäße Verfahren ermöglicht ein Bauteil einstückig zu fertigen und dabei eine Leiterbahn mit in das Bauteil zu integrieren, ohne dass diese Integration die Fertigungsqualität des Bauteils verringert. Dies wird insbesondere dadurch erreicht, dass die Integration der Leiterbahn innerhalb des pulverbettbasierten, additiven Fertigungsprozesses für das Bauteil erfolgt, die Leiterbahn gemeinsam mit dem Bauteil Schicht für Schicht aufgebaut wird. Somit wird die Leiterbahn Schicht für Schicht in das Bauteil integriert.

In einer vorteilhaften Ausgestaltung des Verfahrens kann das Modell der Leiterbahn so innerhalb des Modells des Bauteils positioniert werden, dass die Leiterbahn teilweise aus dem Bauteil herausragt. Dies ist insbesondere vorteilhaft, falls die additive Fertigung mittels Laserstrahlschmelzen erfolgt. In diesem Fall müssen sowohl das Bauteil als auch die Leiterbahn an eine Grundplatte angeschweißt werden, um eine Wärmeableitung zu ermöglichen, um wiederum thermische Spannungen im Bauteil zu reduzieren. Weiterhin ermöglicht ein herausragender Anteil der Leiterbahn, das Bauteil mit weiteren Komponenten elektrisch zu kontaktieren.

Eine weitere vorteilhafte Ausgestaltung des Verfahrens sieht vor, in dem digitalen Gesamtmodell in das Bauteil einen Kanal einzufügen, in welchem die Leiterbahn verläuft und welcher zumindest eine erste Eintrittsöffnung in einer Wand des Bauteils aufweist, durch welche die Leiterbahn zumindest teilweise aus dem Bauteil herausragt. Diese erste Eintrittsöffnung kann als Eingang für die Leiterbahn genutzt werden, wenn diese außerhalb des Bauteils beginnend Schicht für Schicht aufgebaut wird und durch die erste Eintrittsöffnung in das Bauteil hineinwächst.

Weiterhin beinhaltet das Erstellen des digitalen Gesamtmodells vorteilhafterweise, das Modell des Bauteils und das Modell der Leiterbahn derart auf einer virtuellen Bauplattform zu positionieren, dass nach dem Fertigen des Bauteils und der Leiterbahn das Bauteil und die Leiterbahn mit der Bauplattform stoffschlüssig verbunden sind. Hierdurch kann überschüssige Energie in Form von Wärme aus dem Bauteil über die Bauplattform abgeleitet werden, wodurch thermische Spannungen im Bauteil verringert werden.

Weiterhin ist es vorteilhaft, wenn nach dem gemeinsamen Fertigen des Bauteils und der Leiterbahn ein überschüssiges Ausgangsmaterial über die erste Eintrittsöffnung aus dem Bauteil entfernt wird.

Eine weitere mögliche Ausgestaltungsvariante sieht vor, dass der Kanal eine zweite Öffnung in einer Wand des Bauteils aufweist, durch welche nach dem gemeinsamen Fertigen des Bauteils und der Leiterbahn ein überschüssiges Ausgangsmaterial entfernt wird.

In einer weiteren bevorzugten Ausgestaltungsvariante des Verfahrens kann der Kanal nach der Fertigung über die erste oder die zweite Öffnung mit einer Isolationsmasse zur Isolation der Leiterbahn von dem Bauteil aufgefüllt werden. Die Isolationsmasse kann durch Gießen, Einspritzen oder Tauchen des Bauteils in die Isolationsmasse oder mittels chemischer oder physikalischer Gasphasenabscheidung in den Kanal eingebracht werden. Ferner kann die Isolationsmasse eine aushärtbare Isolationsmatrix, einen kunststoff-, keramik- oder harzbasierten Stoff aufweisen oder daraus bestehen.

Ferner kann es vorteilhaft sein, wenn das Bauteil und/oder die Leiterbahn mit einer Stützstruktur gefertigt werden, die nach der gemeinsamen Fertigung des Bauteils und der Leiterbahn durch Ätzen oder Auflösen entfernt wird. Derartige Strukturen halten Bauteilbereiche und/oder die Leiterbahn während des Prozesses. Wird nur die Leiterbahn gehalten, kann eine Stützstruktur nur zwischen Leiterbahn und Bauteil innerhalb des Bauteils gebildet werden.

Die Stützstruktur kann das gleiche Material wie das Bauteil und/oder die Leiterbahn und/oder ein anderes Material als das Bauteil und/oder die Leiterbahn aufweisen oder daraus bestehen, insbesondere kann die Stützstruktur ein nichtleitendes Material, eine lösliche Metallverbindung und/oder Salz aufweisen oder daraus bestehen. Weisen das Bauteil bzw. die Leiterbahn und die Stützstruktur verschiedene Materialien auf, ist für das Verfahren ein Multimaterialprozess, welcher in der Lage ist mindestens zwei Materialien pro Schicht zu verarbeiten, zur Fertigung des Bauteils und der Leiterbahn mit Stützstruktur notwendig.

In einer weiteren vorteilhaften Ausgestaltung der Erfindung kann ein Sensor und/oder ein Aktor in das Bauteil integriert werden, welcher mit der innerhalb des Bauteils verlaufenden Leiterbahn kontaktiert wird.

Insbesondere kann in dem Bauteil ein Hohlraum zur Aufnahme eines Sensors und/oder Aktors vorgesehen sein, das Fertigen des Bauteils und der Leiterbahn auf einer Höhe des Hohlraums unterbrochen werden, der Sensor und/oder Aktor in den Hohlraum eingelegt und mit der Leiterbahn kontaktiert werden und das Fertigen des Bauteils und ggf. der Leiterbahn fortgesetzt werden.

Ferner kann auch zumindest ein Teil der Leiterbahn ein Sensor und/oder Aktor oder ein Bestandteil eines Sensors und/oder Aktors sein.

Der Sensor und/oder Aktor kann insbesondere eine Spule, eine Antenne, ein Kondensator, ein Beschleunigungssensor oder ein Dehnungsmessstreifen sein.

Das Bauteil und die Leiterbahn können das gleiche Material aufweisen oder aus dem gleichen Material bestehen, insbesondere aus dem gleichen Ausgangsmaterial gefertigt werden, oder aus verschiedenen Ausgangsmaterialien, insbesondere mittels eines Multimaterialsystems oder eines Multimaterialprozesses, gefertigt werden.

Das Bauteil und/oder die Leiterbahn können ein Metall, insbesondere ein schweißbares Metall, eine Aluminiumlegierung, Kupfer, Stahl, Titan, eine Nickelbasislegierung, Gold oder Silber aufweisen oder daraus bestehen.

Das pulverbettbasierte, additive Fertigungsverfahren kann ein Laserstrahlschmelzen, Elektronenstrahlschmelzen, Binder Jetting, ein kunststoffbasiertes Verfahren und/oder ein Multimaterialverfahren sein.

Nach der Fertigung können das Bauteil und die Leiterbahn von der Bauplatte z.B. durch Sägen oder Erodieren getrennt werden.

Die Erfindung umfasst weiterhin ein Bauteil mit einer zumindest teilweise innerhalb des Bauteils verlaufenden Leiterbahn und/oder einem sich innerhalb des Bauteils befindlichen Sensors und/oder Aktors, wobei das Bauteil einstückig gefertigt ist. Insbesondere kann das Bauteil mittels eines wie vorstehend beschriebenen Verfahrens herstellbar sein.

Im Folgenden werden Beispiele eines erfindungsgemäßen Verfahrens und eines erfindungsgemäßen Bauteils anhand von Figuren beschrieben. Dabei werden verschiedene erfindungswesentliche oder auch vorteilhafte weiterbildende Elemente im Rahmen dieser Beispiele genannt, wobei auch einzelne dieser Elemente als solche zur Weiterbildung der Erfindung - auch herausgelöst aus dem Kontext des jeweiligen Beispiels und weiterer Merkmale des jeweiligen Beispiels - verwendet werden können. Weiterhin werden in den Figuren für gleiche oder ähnliche Elemente gleiche oder ähnliche Bezugszeichen verwendet und deren Erläuterung daher teilweise weggelassen.

Es zeigen
- Figur 1: einen Aufbau zur Durchführung eines Teils eines erfindungsgemäßen Verfahrens gemäß dem ersten Ausführungsbeispiel,
- Figuren 2a)-2f): Schritte eines erfindungsgemäßen Verfahrens gemäß dem ersten Ausführungsbeispiel in Schliff-Ansichten,
- Figuren 2g)i)-2g)iii): ein Bauteil mit zumindest teilweise innerhalb des Bauteils verlaufender Leiterbahn gemäß einem ersten Ausführungsbeispiel,
- Figur 3: alternativer Schritt zu Figur 2c) eines erfindungsgemäßen Verfahrens in einer Schliff-Ansicht,
- Figur 4: alternativer Schritt zu Figur 2c) eines erfindungsgemäßen Verfahrens in einer Schliff-Ansicht,
- Figur 5: erfindungsgemäßes Bauteil mit Sensor gemäß einem ersten Ausführungsbeispiel in einer Schliff-Ansicht,
- Figur 6: erfindungsgemäßes Bauteil mit Sensor gemäß einem zweiten Ausführungsbeispiel in einer Schliff-Ansicht,
- Figuren 7a)-7d): Verfahrensschritte zur Herstellung eines Bauteils aus Figur 6 in einer Schliff-Ansicht,
- Figuren 8a), 8b): Anwendungsmöglichkeit eines Bauteils mit integriertem Sensor und
- Figur 9: eine Turbinenschaufel als Beispiel für ein erfindungsgemäßes Bauteil mit integrierten Sensoren in einer Perspektivansicht.

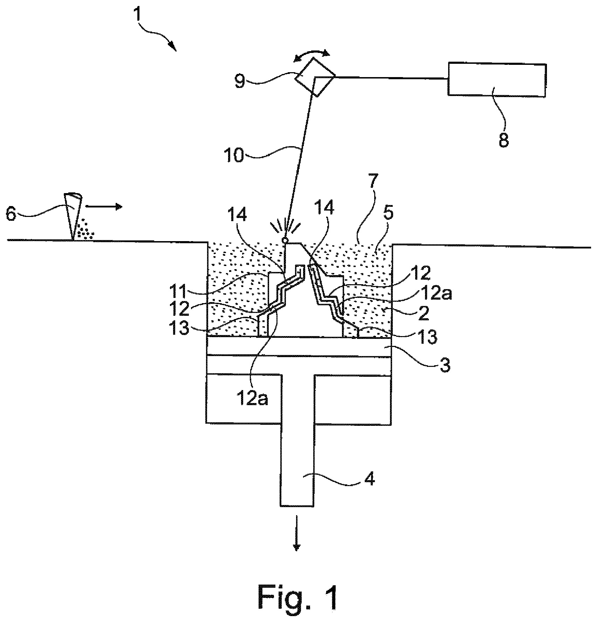

Figur 1 zeigt einen Aufbau 1 zur Durchführung eines Teils eines erfindungsgemäßen Verfahrens gemäß einem ersten Ausführungsbeispiel. Figur 1 zeigt insbesondere einen Aufbau 1 zur gemeinsamen Fertigung eines Bauteils 11 und einer zumindest teilweise in dem Bauteil 11 verlaufenden Leiterbahn 13 mittels Laserstrahlschmelzens. Der Aufbau 1 umfasst einen Bauraum 2, welcher in vertikaler Richtung unten durch eine Bauplattform 3 und oben durch eine Aufbauebene 7 begrenzt wird. Die Bauplattform 2 lässt sich über eine Absenkvorrichtung 4 nach unten absenken, sodass sich der Bauraum 2 vergrößert bzw. der Bauraum 2 an Höhe zunimmt. In dem Bauraum 2 befindet sich das sich in Fertigung befindliche Bauteil 11 mit Leiterbahn 13 eingebettet in einer Schicht 5 aus unverbrauchtem Pulver, die auch mit Pulverbett bezeichnet wird. Die Aufbauebene 7 wird nach jedem Laserstrahlschmelz-Vorgang mittels eines Pulverschiebers 6 mit einer losen Pulverschicht bedeckt. Auf diese lose Pulverschicht trifft ein Laserstrahl 10 und schmilzt das Pulver selektiv, um dem Bauteil 11 eine weitere Schicht hinzuzufügen. Der Laserstrahl 10 stammt aus einer Strahlquelle 11 und wird mittels eines optischen Ablenksystems auf die Aufbauebene 7 gerichtet. Das optische Ablenksystem 9 wird dabei von einer Software gesteuert, die den Laserstrahl 10 gemäß dem digitalen Gesamtmodell in der Aufbauebene 7 bewegt, sodass Schicht für Schicht das gewünschte Bauteil 11 entsteht. Das Bauteil 11 weist Kanäle 12 mit je einer ersten Eintrittsöffnung 12a in gegenüberliegenden Wänden des Bauteils 11 auf. In diesen Kanälen 12 befinden sich Leiterbahnen 13. Sowohl das Bauteil 11 als auch die Leiterbahnen 13 sind an die Bauplattform 3 angeschweißt. Durch die feste Verbindung zur Bauplattform 3 werden die Leiterbahnen 13 auch innerhalb des Bauteils 11 in Position gehalten. Ferner befindet sich in den Kanälen 12 rund um die Leiterbahnen 13 unverbrauchtes Pulver 14, welches die Leiterbahnen 13 innerhalb des Bauteils 11 zusätzlich stützt.

Zu Beginn des additiven Fertigungsprozesses ist die Bauplattform 3 vollständig nach oben geschoben, sodass die Ebene der Bauplattform 3 der Aufbauebene 7 entspricht und der Bauraum 2 im Wesentlichen noch kein Volumen aufweist. Der Pulverschieber 6 verteilt eine lose Pulverschicht als Ausgangsmaterial für das Bauteil 11 und die Leiterbahn 13 auf der Bauplattform 3. Der Laserstrahl 10 wird gemäß dem digitalen Gesamtmodell auf die Pulverschicht gerichtet und mittels des Ablenksystems 9 über die Bauplattform 3 bewegt und so die erste Schicht des Bauteils 11 und der Leiterbahn 13 an die Bauplattform 3 geschweißt. Als Nächstes verfährt die Absenkvorrichtung 4 die Bauplattform 3 nach unten und mittels des Pulverschiebers 6 wird eine weitere lose Pulverschicht auf die Aufbauebene 7, welche nun der bereits gefertigten ersten Schicht des Bauteils 11 und der Leiterbahnen 13 entspricht, aufgetragen. Anschließend wird der Laserstrahl 10 wieder auf die lose Pulverschicht gerichtet und mittels des Ablenksystem 9 gemäß dem digitalen Gesamtmodell über die Aufbauebene 7 bewegt, sodass eine weitere Schicht des Bauteils 11 und der Leiterbahnen 13 entsteht. Mit fortschreitendem Aufbau des Bauteils 11 und der Leiterbahnen 13 wachsen die Leiterbahnen 13 durch die erste Eintrittsöffnungen 12a in die Kanäle 12 und somit in das Bauteil 11 hinein. Somit wird das Bauteil 11 einstückig gefertigt und dabei die Leiterbahn 13 mit in das Bauteil 11 integriert, ohne dass diese Integration die Fertigungsqualität des Bauteils 11 verringert, das Bauteil 11 also Risse, Poren o.ä. aufweist.

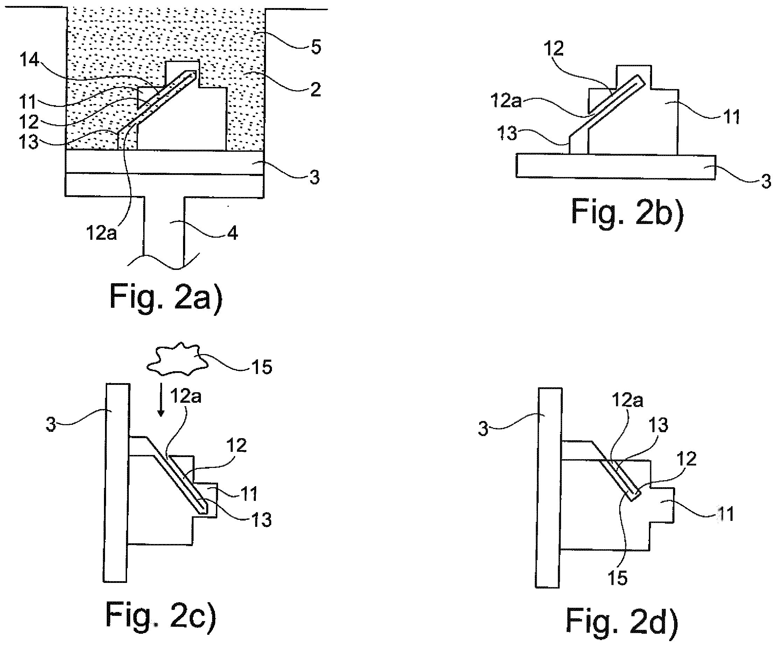

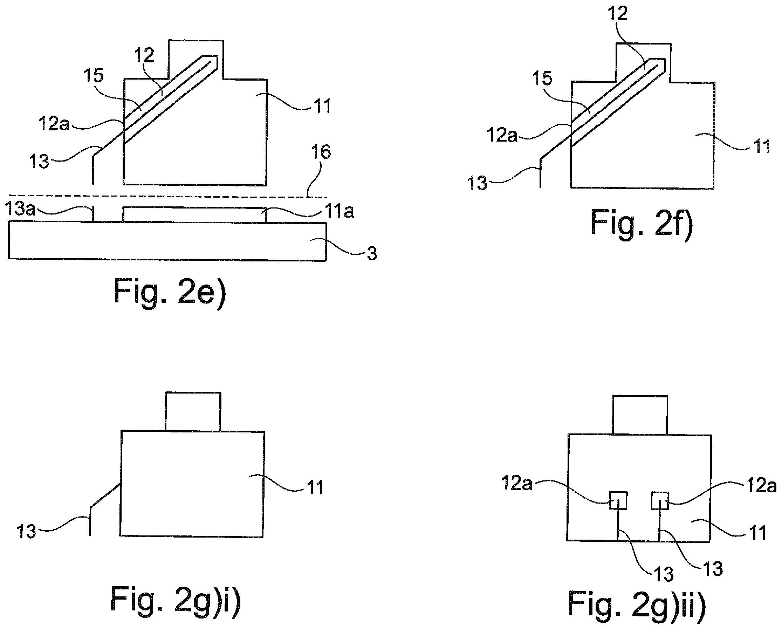

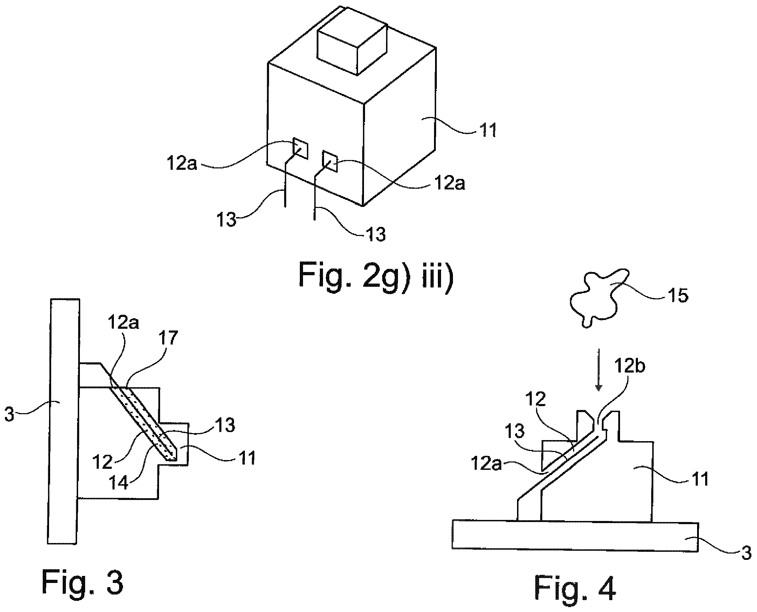

Figuren 2a) bis 2g)iii) zeigen Schritte eines erfindungsgemäßen Verfahrens gemäß dem ersten Ausführungsbeispiel in Schliff-Ansichten. Insbesondere werden Verfahrensschritte gezeigt, die nach der eigentlichen Fertigung mittels Laserstrahlschmelzens wie in Figur 1 dargestellt durchgeführt werden. Figur 2a) zeigt das Bauteil 11 unmittelbar nach dem Aufbau mittels Laserstrahlschmelzens aus Figur 1. Die Bauplattform 3 wurde mittels der Absenkvorrichtung 4 vollständig nach unten verfahren. Das Bauteil 11 befindet sich im Bauraum 2, der mit einem Pulverbett 5 aus unverbrauchtem Pulver gefüllt ist. Sowohl das Bauteil 11 als auch die zumindest teilweise innerhalb des Bauteils 11 verlaufende Leiterbahn 13 (hier ist alternativ zur Figur 1 ein Bauteil mit nur einer innen verlaufenden Leiterbahn 13 gezeigt) sind an die Bauplattform 3 angeschweißt. Die Leiterbahn 13 beginnt somit auf der Bauplattform 2 und führt dann durch die erste Eintrittsöffnung 12a in den Kanal 12 des Bauteils 11 hinein. In dem Kanal 12 befindet sich ebenfalls unverbrauchtes Pulver 14, das die Leiterbahn 13 im Kanal 12 stützt.

Nach dem additiven Fertigungsprozess wird die Bauplattform 3, auf der das Bauteil 11 mit der Leiterbahn 13 befestigt sind aus dem Bauraum 2 herausgenommen und das unverbrauchte Pulver 5 von Bauplattform 3, Bauteil 11 und Leiterbahn 13 entfernt. Figur 2b) zeigt nun die isolierte Bauplattform 3, auf der das Bauteil 11 und die Leiterbahn 13 befestigt sind. Durch die Befestigung der Leiterbahn 13 an der Bauplattform 3 und ihre Steifigkeit wird die Leiterbahn 13 innerhalb des Kanals 12 des Bauteils in Position gehalten und verhindert, dass die Leiterbahn 13 das Bauteil 11 berührt.

In einem nächsten Schritt, der in Figur 2c) dargestellt ist, wird nun eine flüssige, aushärtbare Isolationsmatrix 15 durch die erste Eintrittsöffnung 12a in den Kanal 12 eingegossen. Die Isolationsmatrix 15 hat die Aufgabe, die Leiterbahn 13 nach der Trennung des Bauteils 11 und der Leiterbahn 13 von der Bauplattform 3 innerhalb des Kanals 12 in Position zu halten und von dem Bauteil 12 elektrisch zu isolieren.

Figur 2d) zeigt das Bauteil 11 mit der Leiterbahn 13 nach dem Aushärten der Isolationsmatrix 15. Der Kanal 12 ist vollständig mit der Isolationsmatrix 15 gefüllt, welche die Leiterbahn 13 innerhalb des Bauteils 11 fest in Position hält und gegenüber dem Bauteil 11 elektrisch isoliert. Die Eintrittsöffnung 12a ist fest verschlossen. Bauteil 11 und Leiterbahn 13 sind weiterhin fest mit der Bauplattform 3 verbunden.

Figur 2e) zeigt einen nächsten Schritt, in dem das Bauteil 11 und die Leiterbahn 13 von der Bauteilplattform 3 getrennt werden. Hier werden das Bauteil 11 und die Leiterbahn 13 knapp oberhalb der Bauplattform 3 entlang einer Trennungsebene 16 durch Sägen von der Bauplattform 3 getrennt. Dabei bleibt jeweils ein Rest 13a der Leiterbahn 13 und ein Rest 11a des Bauteils 11 auf der Bauplattform 3 stehen.

In Figur 2f) ist das von der Bauplattform 3 abgetrennte Bauteil 11 und die von der Bauplattform 13 abgetrennte Leiterbahn 13 gezeigt. Durch die Trennung von Bauteil 11 und Leiterbahn 13 von der Bauplattform 3 sind Leiterbahn 13 und Bauteil 11 nun vollständig voneinander elektrisch isoliert.

Figuren 2g)i)-2g)iii) zeigen das Bauteil 11 mit zumindest teilweise innerhalb des Bauteils 11 verlaufender Leiterbahn 13 aus Figur 2f) in verschiedenen äußeren Ansichten. Figur 2g)i) zeigt das Bauteil 11 mit der Leiterbahn 13 in einer äußeren Vorderansicht. Die Leiterbahn 13 ragt teilweise seitlich aus dem Bauteil 11 heraus.

Figur 2g)ii) zeigt das Bauteil 11 mit den Leiterbahnen 13 in einer äußeren Vorderansicht. Das Bauteil 11 verfügt in diesem Fall über zwei innerhalb des Bauteils 11 verlaufende Leiterbahnen 13, die nebeneinander aus Eintrittsöffnungen 12a von Kanälen 12 des Bauteils 11 herausragen.

Figur 2g)iii) zeigt das Bauteil 11 mit den Leiterbahnen 13 in einer äußeren Perspektivansicht von schräg vorne.

Figur 3 zeigt eine alternative Möglichkeit zur Stützung der Leiterbahn 13 innerhalb des Kanals 12 des Bauteils 11 und elektrischen Isolation der Leiterbahn 13 gegenüber dem Bauteil 11 im Vergleich zu Figur 2c). In Figur 3 verbleibt nachdem Entfernen des unverbrauchten Pulvers vom Bauteil 11 und der Bauplattform 3 das sich in dem Kanal 12 befindliche unverbrauchte Pulver 14. Um ein Herauslaufen des Pulvers 14 aus dem Kanal 12 zu verhindern, wird die Eintrittsöffnung 12a mit einer Versiegelung 17 versehen. Das unverbrauchte Pulver 14 in dem Kanal 12 hält nun anstelle der Isolationsmatrix 15 aus Figur 2d) die Leiterbahn 13 in dem Kanal 12 in Position und isoliert die Leiterbahn 13 elektrisch vom Bauteil 11.

Figur 4 zeigt einen alternativen Schritt zu Figur 2c) eines erfindungsgemäßen Verfahrens in einer Schliff-Ansicht. Hier verfügt das Bauteil 11 auf einer der ersten Eintrittsöffnung 12a gegenüberliegenden Seite des Bauteils 11 über eine zweite Öffnung 12b, in welche die flüssige, aushärtbare Isolationsmatrix 15 zur Stützung und elektrischen Isolation der Leiterbahn 13 in den Kanal 12 des Bauteils 11 eingegossen werden kann.

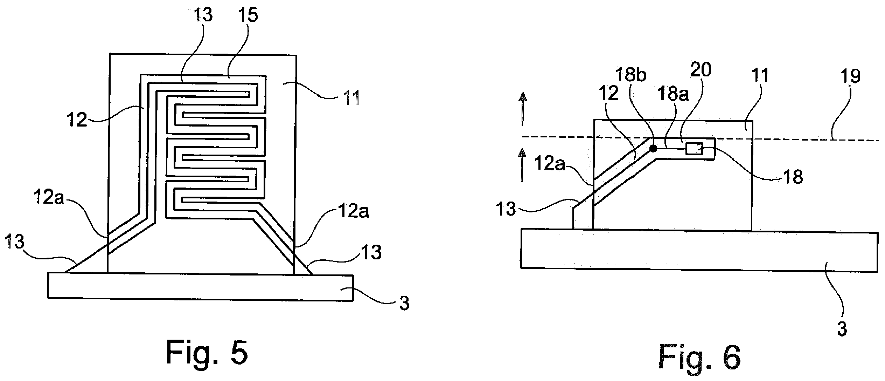

Figur 5 zeigt ein erfindungsgemäßes Bauteil mit einem Sensor gemäß einem ersten Ausführungsbeispiel in einer Schliff-Ansicht. Der Sensor wird hier von einem mittleren Teil der Leiterbahn 13 gebildet. Das Bauteil 11 weist einen Kanal 12 mit ersten Eintrittsöffnungen 12a an gegenüberliegenden Seiten des Bauteils 11 auf. Im mittleren Bereich ist der Kanal 12 in vertikaler Richtung mäanderförmig gewunden. Die Leiterbahn 13 führt von der ersten Eintrittsöffnung 12a zur nächsten auf der gegenüberliegenden Seite des Bauteils 11 durch den Kanal 12 und folgt im mittleren Bereich den mäanderförmigen Windungen des Kanals 12, sodass die Leiterbahn 13 Schleifen bildet. Ein derartiger Sensor kann eine Spule, eine Antenne, ein Dehnungsmessstreifen etc. sein.

Figur 6 zeigt ein erfindungsgemäßes Bauteil mit einem Sensor gemäß einem zweiten Ausführungsbeispiel in einer Schliff-Ansicht. Bis auf den Hohlraum 20 für den Sensor 18 und den eingefügten Sensor 18 ist das in Figur 6 gezeigte Bauteil 11 mit Leiterbahn 13 wie in den vorangegangen Figuren ausgebildet. Das Bauteil 11 und die Leiterbahn 13 sind noch auf der Bauplattform 3 befestigt. Der Sensor 18 wird in diesem Fall während des additiven Fertigungsprozesses in das Bauteil 11 eingelegt. Zunächst wird zusätzlich zu einem Kanal 12 ein Hohlraum 20 für den Sensor 18 in dem Bauteil 11 im digitalen Gesamtmodell, auf dessen Grundlage das Bauteil mit der Leiterbahn gefertigt wird, vorgesehen. Dabei ist der Hohlraum 20 mit dem Kanal 12 verbunden um eine elektrische Kontaktierung zu ermöglichen. Bevor in dem additiven Fertigungsprozess der Hohlraum 20 in vertikaler Richtung verschlossen wird, wird der Fertigungsprozess auf einer Fertigungsprozessunterbrechungsebene 19 unterbrochen und der Sensor 18 zusammen mit einem Sensordraht 18a in das Bauteil 11 eingelegt. Der Sensordraht 18a wird mit der Leiterbahn 13 an einer Kontaktstelle 18b kontaktiert. Anschließend wird das Fertigungsverfahren fortgesetzt, wobei der Hohlraum 20 für den Sensor 18 verschlossen wird.

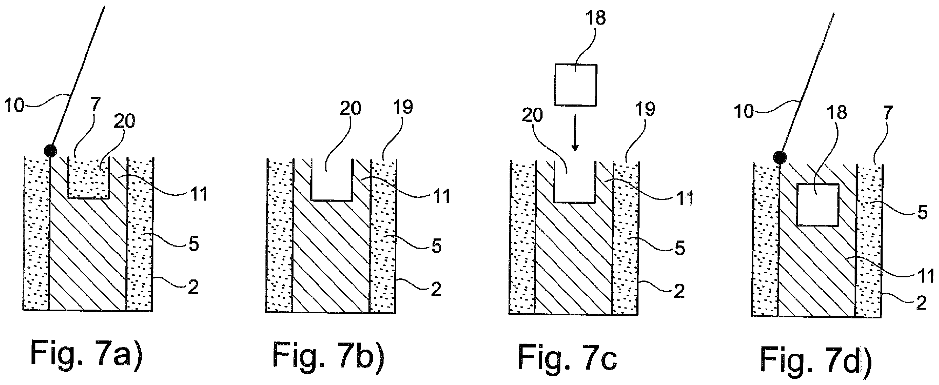

Figuren 7a)-7d) zeigt die Sensoreinlegung in das Bauteil 11 durch Unterbrechen des Fertigungsprozesses nochmals im Detail. Figur 7a) zeigt das Bauteil 11 im Pulverbett des unverbrauchten Pulvers 5 innerhalb des Bauraums 2. In der Aufbauebene 7 formt der Laserstrahl 10 eine weitere Schicht des Bauteils 11, welches im oberen Bereich einen Hohlraum 20 zur Aufnahme eines Sensors 18 aufweist. In Figur 7b) ist nun der Fertigungsprozess auf einer Fertigungsprozessunterbrechungsebene 19 unterbrochen und das unverbrauchte Pulver aus dem Hohlraum 20 wurde entfernt. In Figur 7c) wird der Sensor 18 in dem Hohlraum 20 des Bauteils 11 platziert. In Figur 7d) wird anschließend der Fertigungsprozess auf der Fertigungsprozessunterbrechungsebene 19 fortgesetzt und der Hohlraum 20 mit eingelegtem Sensor 18 verschlossen, sodass der Sensor 18 in dem Bauteil 11 eingeschlossen ist. Das Verfahren der Sensoreinlegung durch Fertigungsprozessunterbrechung kann sowohl manuell als auch automatisiert ablaufen. Anstatt eines Sensors kann mit dem gleichen Verfahren auch ein Aktor in ein Bauteil integriert werden.

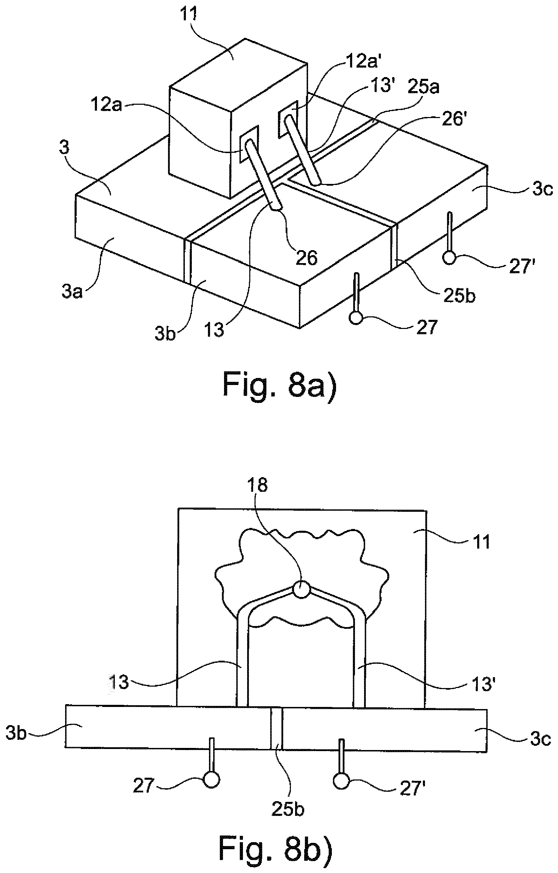

Figuren 8a) und 8b) zeigen ein Bauteil 11 mit einem integrierten Sensor 18, der zur Prozessüberwachung in einem additiven Fertigungsprozess verwendet werden kann. Figur 8a) zeigt das Bauteil 11 mit dem Sensor 18 zur Prozessüberwachung in einer äußeren Perspektivansicht. Figur 8b) zeigt das Bauteil 11 mit dem Sensor 18 in einer Vorderansicht. Der Sensor 18 ist in das Bauteil 11 integriert und mit den Leiterbahnen 13, 13', welche aus den Eintrittsöffnungen 12a, 12a' teilweise herausragen, kontaktiert. In Figur 8b) ist der Sensor 18 mittig im Bauteil 11 durch einen Ausbruch der Skizze dargestellt. Das Bauteil 11 und die Leiterbahnen 13, 13' sind fest mit der Bauplattform 3 verbunden. Anders als in den vorangegangenen Figuren ist die Bauplattform 3 in den Figuren 8a) und 8b) in drei voneinander elektrisch isolierte Bereiche 3a, 3b und 3c geteilt. Dabei befindet sich das Bauteil 11 auf einem ersten Teil 3a. Der erste Teil 3a ist durch eine elektrische Isolationsschicht 25a von dem zweiten Teil 3b und dem dritten Teil 3c der Bauplattform 3 getrennt. Eine elektrische Isolationsschicht 25b trennt den zweiten Teil 3b und den dritten Teil 3c elektrisch voneinander. Die aus der Eintrittsöffnung 12a heraus ragende Leiterbahn 13 ist an einer Kontaktstelle 26 mit dem zweiten Teil 3b der Bauplattform 3 kontaktiert. Weiterhin weist der zweite Teil 3b einen Anschluss 27 zur Messwerterfassung auf. Die aus der Eintrittsöffnung 12a' herausragende Leiterbahn 13' ist an einer Kontaktstelle 26' mit dem dritten Teil 3c der Bauplattform 3 kontaktiert. Weiterhin weist der dritte Teil 3c einen Anschluss 27' zur Messwerterfassung auf.

Die gemäß dem vorliegenden Verfahren zusammen mit dem Bauteil 11 additiv gefertigten Leiterbahnen 13, 13' ermöglichen eine Leitung von elektrischen Signalen bereits während des Fertigungsprozesses. Damit können bereits während des Fertigungsprozesses Daten über den Fertigungsprozess erfasst werden. Diese Daten können beispielsweise Temperaturdaten oder erfasste Kräfte sein, welche durch integrierte Sensoren aufgezeichnet werden. Die integrierten Sensoren können je nach Sensortyp sowohl eingelegte Sensoren sein als auch Sensoren, die von zumindest einem Teil der Leiterbahnen selbst gebildet werden. Ferner kann die Prozessüberwachung auch darin bestehen zu prüfen, ob ein eingelegter bzw. integrierter Sensor ordnungsgemäß elektrisch ankontaktiert ist.

Wie oben bereits beschrieben ist, kann dazu eine spezielle Bauplattform genutzt werden, welche in mehrere elektrisch voneinander isolierte Bestandteile getrennt ist. Durch den Aufbau auf der einen bzw. anderen Seite der Bauplattform lassen sich verschiedene Leiterbahnen oder auch das Bauteil selbst bereits während des Prozesses elektrisch voneinander trennen. Dadurch können elektrische Signale wie z.B. Widerstände bereits während des Fertigungsprozesses erfasst werden.

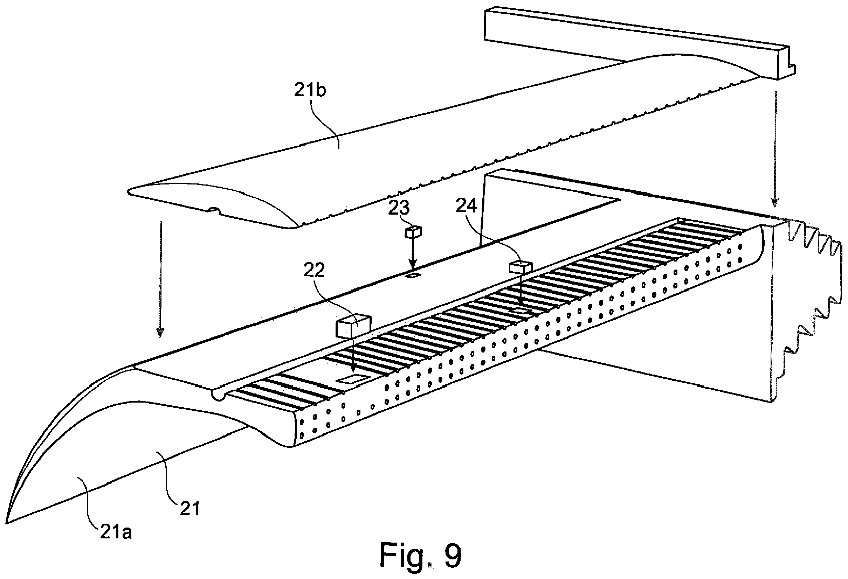

Figur 9 zeigt eine Turbinenschaufel als Beispiel für ein erfindungsgemäßes Bauteil mit integrierten Sensoren in einer Perspektivansicht. Die Turbinenschaufel 21 kann mit dem erfindungsgemäßen Verfahren gefertigt werden. Verschiedene Sensoren können dabei in die Turbinenschaufel integriert werden. Die Turbinenschaufel 21 weist einen unteren Teil 21a und einen oberen Teil 21b auf. Stromaufwärtsseitig der Turbinenschaufel 21 sind ein Thermoelement 22 und ein Flusssensor 24 in den unteren Teil 21a der Turbinenschaufel 21 integriert. Stromabwärtsseitig der Turbinenschaufel 21 sind ein oder mehrere Dehnungsmessstreifen 23 in den unteren Teil 21b der Turbinenschaufel 21 integriert.

Des Weiteren kann die vorliegende Erfindung noch die folgenden Aspekte umfassen:
1. Verfahren nach einem der vorhergehenden Aspekte, dadurch gekennzeichnet, dass das Erstellen des digitalen Gesamtmodells weiterhin beinhaltet, das Modell des Bauteils und das Modell der Leiterbahn derart auf einer virtuellen Bauplattform zu positionieren, dass nach dem Fertigen des Bauteils und der Leiterbahn das Bauteil und die Leiterbahn mit der Bauplattform stoffschlüssig verbunden sind.
2. Verfahren nach einem der vorhergehenden Aspekte, dadurch gekennzeichnet, dass nach dem gemeinsamen Fertigen des Bauteils und der Leiterbahn ein überschüssiges Ausgangsmaterial über die erste Eintrittsöffnung aus dem Bauteil entfernt wird.
3. Verfahren nach einem der vorhergehenden Aspekte, dadurch gekennzeichnet, dass der Kanal eine zweite Öffnung in einer Wand des Bauteils aufweist, durch welche nach dem gemeinsamen Fertigen des Bauteils und der Leiterbahn ein überschüssiges Ausgangsmaterial entfernt wird.
4. Verfahren nach einem der vorhergehenden Aspekte, dadurch gekennzeichnet, dass die Isolationsmasse durch Gießen, Einspritzen oder Tauchen des Bauteils in die Isolationsmasse oder mittels chemischer oder physikalischer Gasphasenabscheidung in den Kanal eingebracht wird.
5. Verfahren nach einem der vorhergehenden Aspekte, dadurch gekennzeichnet, dass die Isolationsmasse eine aushärtbare Isolationsmatrix, einen kunststoff-, keramik- oder harzbasierten Stoff aufweist oder daraus besteht.
6. Verfahren nach einem der vorhergehenden Aspekte, dadurch gekennzeichnet, dass die Stützstruktur das gleiche Material wie das Bauteil und/oder die Leiterbahn und/oder ein anderes Material als das Bauteil und/oder die Leiterbahn aufweist oder daraus besteht, insbesondere dass die Stützstruktur ein nichtleitendes Material aufweist oder daraus besteht.
7. Verfahren nach einem der vorhergehenden Aspekte, dadurch gekennzeichnet, dass der Sensor und/oder Aktor eine Spule, eine Antenne, ein Kondensator, ein Beschleunigungssensor oder ein Dehnungsmessstreifen ist.
8. Verfahren nach einem der vorhergehenden Aspekte, dadurch gekennzeichnet, dass das Bauteil und die Leiterbahn das gleiche Material aufweisen oder aus dem gleichen Material bestehen, insbesondere aus dem gleichen Ausgangsmaterial gefertigt werden, oder dass das Bauteil und die Leiterbahn aus verschiedenen Ausgangsmaterialien, insbesondere mittels eines Multimaterialsystems, gefertigt werden.
9. Verfahren nach einem der vorhergehenden Aspekte, dadurch gekennzeichnet, dass das Bauteil und/oder die Leiterbahn ein Metall, insbesondere ein schweißbares Metall, eine Aluminiumlegierung, Kupfer, Stahl, Titan, eine Nickelbasislegierung, Gold oder Silber aufweist oder daraus besteht.
10. Verfahren nach einem der vorhergehenden Aspekte, dadurch gekennzeichnet, dass das pulverbettbasierte, additive Fertigungsverfahren ein Laserstrahlschmelzen, Elektronenstrahlschmelzen, Binder Jetting, ein kunststoffbasiertes Verfahren und/oder ein Multimaterialverfahren ist.
11. Verfahren nach einem der vorhergehenden Aspekte, dadurch gekennzeichnet, dass nach der Fertigung das Bauteil und die Leiterbahn von der Bauplatte z.B. durch Sägen oder Erodieren getrennt werden.

## Patentansprüche

1. Verfahren zur Herstellung eines Bauteils mit einer zumindest teilweise innerhalb des Bauteils verlaufenden Leiterbahn mittels eines pulverbettbasierten, additiven Fertigungsverfahrens, wobei das Verfahren umfasst:
- Erstellen eines digitalen Modells des Bauteils und eines digitalen Modells der Leiterbahn,
- Erstellen eines digitalen Gesamtmodells, wobei das Modell der Leiterbahn innerhalb des Modells des Bauteils positioniert wird,
- gemeinsames Fertigen des Bauteils und der zumindest teilweise innerhalb des Bauteils verlaufenden Leiterbahn mittels des pulverbettbasierten, additiven Fertigungsverfahrens.

2. Verfahren nach dem vorhergehenden Anspruch, **dadurch gekennzeichnet, dass** das Modell der Leiterbahn so innerhalb des Modells des Bauteils positioniert wird, dass die Leiterbahn teilweise aus dem Bauteil herausragt.

3. Verfahren nach einem der vorhergehenden Ansprüche, **dadurch gekennzeichnet, dass** in dem digitalen Gesamtmodell in das Bauteil ein Kanal eingefügt wird, in welchem die Leiterbahn verläuft und welcher zumindest eine erste Eintrittsöffnung in einer Wand des Bauteils aufweist, durch welche die Leiterbahn zumindest teilweise aus dem Bauteil herausragt.

4. Verfahren nach dem vorhergehenden Anspruch, **dadurch gekennzeichnet, dass** der Kanal nach der Fertigung über die erste Eintrittsöffnung oder die zweite Öffnung mit einer Isolationsmasse zur Isolation der Leiterbahn von dem Bauteil aufgefüllt wird.

5. Verfahren nach einem der vorhergehenden Ansprüche, **dadurch gekennzeichnet, dass** das Bauteil und/oder die Leiterbahn mit einer Stützstruktur gefertigt werden, die nach der gemeinsamen Fertigung des Bauteils und der Leiterbahn durch Ätzen oder Auflösen entfernt wird.

6. Verfahren nach einem der vorhergehenden Ansprüche, **dadurch gekennzeichnet, dass** ein Sensor und/oder ein Aktor in das Bauteil integriert wird, welcher mit der innerhalb des Bauteils verlaufenden Leiterbahn kontaktiert wird.

7. Verfahren nach einem der vorhergehenden Ansprüche, **dadurch gekennzeichnet, dass** in dem Bauteil ein Hohlraum zur Aufnahme eines Sensors und/oder Aktors vorgesehen ist, das Fertigen des Bauteils und der Leiterbahn auf einer Höhe des Hohlraums unterbrochen wird, der Sensor und/oder Aktor in den Hohlraum eingelegt und mit der Leiterbahn kontaktiert wird und das Fertigen des Bauteils und ggf. der Leiterbahn fortgesetzt wird.

8. Verfahren nach einem der Ansprüche 1 bis 6, **dadurch gekennzeichnet, dass** zumindest ein Teil der Leiterbahn ein Sensor und/oder Aktor oder ein Bestandteil eines Sensors und/oder Aktors ist.

9. Bauteil mit einer zumindest teilweise innerhalb des Bauteils verlaufenden Leiterbahn und/oder einem sich innerhalb des Bauteils befindlichen Sensors und/oder Aktors, wobei das Bauteil einstückig gefertigt ist.

10. Bauteil nach dem vorhergehenden Anspruch, wobei das Bauteil mittels eines Verfahrens nach einem der Ansprüche 1 bis 8 herstellbar ist.
